Europäisches Patentamt

European Patent Office

Office européen des brevets

(11) Veröffentlichungsnummer: **0 238 683**
**A1**

# EUROPÄISCHE PATENTANMELDUNG

(21) Anmeldenummer: **86104060.8**

(22) Anmeldetag: **25.03.86**

(51) Int. Cl.⁴: **H03K 3/55** , H01S 3/097

Die Anmeldung wird, wie ursprünglich eingereicht, unvollständig veröffentlicht (Art. 93 (2) EPÜ). Am Ende der Beschreibung fehlt ein Stuck Text.

Ein Antrag gemäss Regel 88 EPÜ auf Hinzufügung der fehlenden Seite 5 (Beschreibung) liegt vor. Über diesen Antrag wird im Laufe des Verfahrens von der Prüfungsabteilung eine Entscheidung getroffen werden (Richtlinien für die Prüfung im EPA, A-V, 2.2).

(43) Veröffentlichungstag der Anmeldung:
**30.09.87 Patentblatt 87/40**

(84) Benannte Vertragsstaaten:
**AT BE CH DE FR GB IT LI LU NL SE**

(71) Anmelder: **Lambda Physik Forschungs- und Entwicklungsgesellschaft mbH**
**Hans-Böckler-Strasse 12**
**D-3400 Göttingen(DE)**

(72) Erfinder: **Rückle, Benno, Dr.**
**Friedrichstrasse 1**
**D-3400 Göttingen(DE)**
Erfinder: **Mehmke, Bernd**
**Lange Strasse 38**
**D-3423 Bad Sachsa 2 Neuhof(DE)**

(74) Vertreter: **Frohwitter, Bernhard, Dipl.-Ing. et al**
**Bardehle-Pagenberg-Dost-Altenburg & Partner Patent- und Rechtsanwälte**
**Galileiplatz 1 Postfach 86 06 20**
**8000 München 80(DE)**

(54) **Vorrichtung zur Erzeugung von Hochleistungs-Hochspannungsimpulsen.**

(57) Eine Vorrichtung zur Erzeugung von Hochleistungs-Hochspannungsimpulsen für mehrere Verbraucher, insbesondere entladungsgepumpte Laser, unter Verwendung eines einzigen Schalters (S1) wird angegeben, die einen Schwingkreis aus einer Kapazität (C1), einer Induktivität (L1) und dem Schalter (S1) aufweist, bei dem die Kapazität (C1) parallel zur Reihenschaltung des Schalters (S1) mit der Induktivität (L1) liegt, und der über eine in Reihe zu dem Schwingkreis (S1, L1, C1) liegende sättigbare Induktivität (S2) mit den Verbrauchern verbunden ist.

Fig. 2

EP 0 238 683 A1

## Vorrichtung zur Erzeugung von Hochleistungs-Hochspannungsimpulsen

Die Erfindung betrifft eine Vorrichtung zur Erzeugung von Hochleistungs-Hochspannungsimpulsen für mehrere Verbraucher, insbesondere TE-Laser, mittels eines einzigen Schalters.

Bei Impulslasern mit hohen Einzelpulsleistungen oder hohen Repetitionsraten müssen große Energien und Leistungen geschaltet werden, was mit bisherigen Schaltern, insbesondere Thyratrons, nur bedingt möglich ist, da die für solche Impulslaser nötigen Schaltanforderungen die Lebensdauer des Schaltelementes herabsetzen. Des weiteren ist für einen Oszillator-Verstärker-Betrieb eine Verzögerung der Entladungen der einzelnen Oszillator-bzw. Verstärker-Stufen gegeneinander von einigen Nanosekunden (ns) notwendig, welche keinen Jitter aufweisen darf. Dies läßt sich vorteilhaft erreichen, indem man einen gemeinsamen Schalter für zwei oder mehrere Entladungssysteme verwendet. Dadurch wird jedoch die Belastung des Schalters noch höher, wie es in den bisherigen Oszillator-Verstärker-Systemen mit gemeinsamen Schalter der Fall ist.

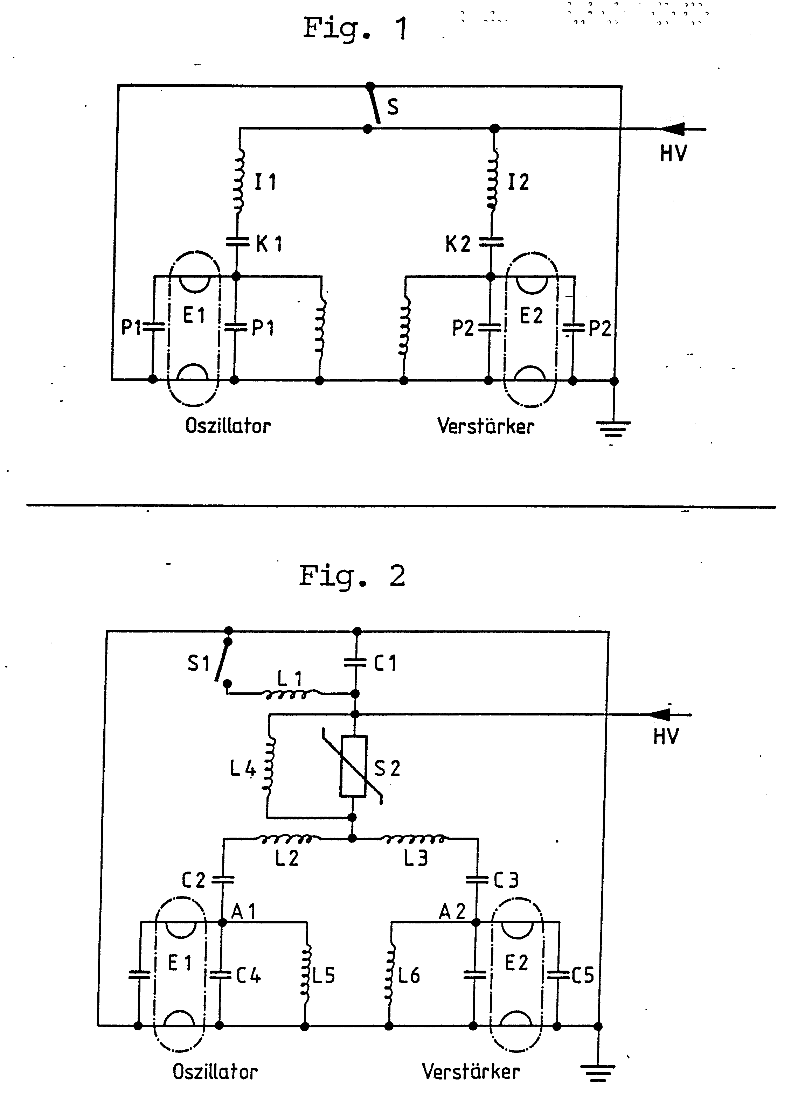

Eine solche Oszillator-Verstärker-Schaltung, wie sie beispielsweise im Modell EMG 150 der Anmelderin realisiert ist, ist in Fig. 1 dargestellt. Die Speicher-Kondensatoren K1, K2 werden in vergleichsweise langen Zeiten aufgeladen und durch Schließen des Schalters S in einigen 10 ns umgeladen. Diese Umladung führt zur Aufladung der Kondensatoren P1 und P2 und anschließend zur Zündung der Entladungen E1, E2. Der Stromdurchgang durch die Entladung muß bei vielen Lasergasen rasch hohe Werte erreichen, deshalb muß der Spannungsanstieg an den Kondensatoren schnell sein. Für den Schalter hat dies ein hohes und - schädliches Anwachsen des Stromes di/dt zur Folge. Die Erzeugung der Verzögerung wird durch ungleiche Induktivitäten I1 und I2 in den Umladungskreisen und durch unterschiedliche Entladungskammern E1, E2, erzeugt.

Darüber hinaus sind aus der DE-A 32 40 372 und der DE-A 33 35 690 Schaltkreise mit verlangsamtem, das Schaltelement schonendem Verlauf und magnetisch sättigbaren Induktivitäten zur nachfolgenden Inpulsverkürzung bekannt, die jedoch nur eine einzige Laserentladung speisen.

Es ist dementsprechend eine Aufgabe der vorliegenden Erfindung, eine Vorrichtung anzugeben, mit der die Lebensdauer eines hochbelasteten Schalters, über den mehrere Verbraucher gespeist werden, erheblich verlängert wird.

Diese Aufgabe wird erfindungsgemäß durch eine Vorrichtung nach Anspruch 1 gelöst.

Vorteilhafterweise wird die Betriebszuverlässigkeit erhöht und ein Betrieb mit hoher Repetitionsrate (>500 Hz) und hoher Pulsleistung ermöglicht. Laserentladungen in mehreren Verbrauchern können gegeneinander um einige ns jitterfrei verzögert werden. Die Vorrichtung dient vorteilhafterweise zur Erzeugung von Hochleistungs-Hochspannungsimpulsen in Verbrauchern, die eine Reihenschaltung aus einer zweiten Induktivität, einer zweiten Kapazität und einer Parallelschaltung aus einer Entladungsstrecke, einer dritten Kapazität und einer dritten Induktivität aufweisen.

Zur Erzielung einer zeitlichen Verzögerung der Hochspannungs-Hochleistungimpulse in den einzelnen Verbrauchern zueinander können die zweiten Kapazitäten, die zweiten Induktivitäten oder die dritten Kapazitäten vorteilhafterweise in jedem Verbraucher unterschiedlich groß dimensioniert werden. Ebenso können die Entladungsstrecken unterschiedliche Gasdrücke oder Gaszusammensetzungen oder Entladungsgeometrien aufweisen, um die gewünschte zeitliche Verzögerung der einzelnen Verbraucher zueinander zu erzielen.

Parallel zu der sättigbaren Induktivität ist vorteilhafterweise eine vierte Induktivität parallelgeschaltet, die die nach der Entladung der Kapazitäten verbleibende Restladung zum Ladepunkt abführt.

Parellel zu den Entladungsstrecken liegende dritte Induktivitäten verbinden die zweiten Kapazitäten gleichspannungsmäßig mit Masse.

Weitere Vorteile, Merkmale und Anwendungsmöglichkeiten der vorliegenden Erfindung ergeben sich aus der nachfolgenden Beschreibung eines Ausführungsbeispiels in Verbindung mit der Zeichnung. Darin zeigen:

Fig. 1 eine Vorrichtung zur Erzeugung von Hochspannungsimpulsen nach dem Stand der Technik und

Fig. 2 eine Ausführungsform der erfindungsgemäßen Vorrichtung zur Erzeugung von Hochleistungs-Hochspannungsimpulsen.

Fig. 2 zeigt eine Hochspannungsversorgung HV, die mit einem Schwingkreis verbunden ist. Dieser Schwingkreis weist eine Kapazität C1, eine Induktivität L1 und einen Schalter S1 auf. Die Kapazität C1 ist zwischen die Hochspannungsversorgung HV und Masse geschaltet. Parallel zu dieser Kapazität C1 liegt eine Reihenschal tung der Induktivität L1 und des Schalters S1.

An dem Punkt, an dem die Hochspannungsversorgung HV mit dem Schwingkreis C1, L1, S1 verbunden ist, ist eine sättigbare Induktivität S2 mit dem Schwingkreis verbunden. Parallel zu dieser sättigbaren Induktivität S2 liegt eine vierte Induktivität L4.

Am anderen Ende der sättigbaren Induktivität S2 sind Verbraucher angeschlossen. Im vorliegenden Ausührungsbeispiel sind zwei Verbraucher gezeigt. Diese sind als "Oszillator" und "Verstärker" bezeichnet. Jeder Verbraucher weist eine Reihenschaltung auf, in der eine zweite Induktivität L2, L3, eine zweite Kapazität C2, C3 und eine Parallelschaltung aus einer Entladungsstrecke E1, E2, einer dritten Kapazität C4, C5 und einer dritten Induktivität L5, L6 hintereinander geschaltet sind.

Durch die Verwendung einer magnetisch gesättigten Induktivität in der dargestellten abgewandelten Blümlein-Schaltung kann der Umladestrom durch den Schalter S1 in seinem Stromanstieg und in seinem Spitzenstrom reduziert werden, was zu einer Erhöhung der Lebensdauer und zu einem zuverlässigen Schaltbetrieb führt. Durch die beiden Kapazitäten C2 und C3 läß sich eine Entkopplung der Entladungen in den Entladungsstrecken E1 und E2 voneinander erzielen. Durch die unterschiedliche Dimensionierung der Kapazitäten C4 und C5 kann ein unterschiedlicher Spannungsanstieg an den Elektroden der Entladungsstrecken erreicht werden, was bei gleicher Durchbruchspannung (gleicher Elektrodenabstand und gleicher Gasdruck) zu einer festen Verzögerung der Entladung zwischen den Entladungsstrecken E1 und E2 führt.

Anhand der in Fig. 2 dargestellten Schaltung wird nun die Wirkungsweise der Vorrichtung beschrieben. Nach

**Ansprüche**

1. Vorrichtung zur Erzeugung von Hochleistungs-Hochspannungsimpulsen für mehrer Verbraucher, insbesondere TE-Laser, unter Verwendung eines einzigen Schalters (S1), **gekennzeichnet** durch einen Schwingkreis aus einer Kapazität (C1), einer Induktivität (L1) und dem Schalter (S1), bei dem die Kapazität (C1) parallel zur Reihenschaltung des Schalters (S1) mit der Induktivität (L1) liegt, und der über eine in Reihe zu dem Schwingkreis (S1, L1, C1) liegende sättigbare Induktivität (S2) mit den Verbrauchern verbunden ist.

2. Vorrichtung nach Anspruch 1, dadurch gekennzeichnet, daß der Schwingkreis (C1, L1, S1) mit Verbrauchern verbunden ist, die eine Reihenschaltung aus einer zweiten Induktivität (L2, L3) einer zweiten Kapazität (C2, C3) und einer Parallelschaltung aus einer Entladungsstrecke (E1, E2), einer dritten Kapazität (C4, C5) und einer dritten Induktivität (L5, L6) aufweisen.

3. Vorrichtung nach Anspruch 2, dadurch gekennzeichnet, daß die dritten Kapazitäten (C4, C5) zue Erzielung einer zeitlichen Verzögerung der Hochleistungs-Hochspannungsimpulse in den einzelnen Verbrauchern zueinander unterschiedlich dimensioniert sind.

4. Vorrichtung nach Anspruch 2 oder 3, dadurch gekennzeichnet, daß die zweiten Kapazitäten (C2, C3) zue Erzielung einer zeitlichen Verzögerung der Hochleistungs-Hochspannungsimpulse in den einzelnen Verbrauchern zueinander unterschiedlich dimensioniert sind.

5. Vorrichtung nach mindestens einem der Ansprüche 2 bis 4, dadurch gekennzeichnet, daß die zweiten Induktivitäten (L2, L3) zur Erzielung einer zeitlichen Verzögerung der Hochleistungs-Hochspannungsimpulse in den einzelnen Verbrauchern zueinander unterschiedlich dimensioniert sind.

6. Vorrichtung nach mindestens einem der Ansprüche 2 bis 5, dadurch gekennzeichnet, daß die Entladungsstrecken (E1, E2) zur Erzielung einer zeitlichen Verzögerung der Hochleistungs-Hochspannungsimpulse in den einzelnen Verbrauchern zueinander unterschiedliche Gasdrücke und/oder Gaszusammensetzungen und/oder unterschiedliche Entladungsgeometrien aufweisen.

7. Vorrichtung nach mindestens einem der Ansprüche 1 bis 6, gekennzeichnet durch eine zu der sättigbaren Induktivität (S2) parallelgeschaltete vierte Induktivität (L4), die die nach der Entladung der Kapazitäten verbleibende Restladung zu einem Ladepunkt (HV) abführt.

8. Vorrichtung nach Anspruch 5, dadurch gekennzeichnet, daß die zweiten Induktivitäten (L2, L3) zur Erzielung einer einstellbaren Verzögerung der Hochleistungs-Hochspannungsimpulse in den einzelnen Verbrauchern vom Benutzer während des Betriebes variiert werden können.

9. Vorrichtung nach mindestens einem der Ansprüche 1 bis 8, dadurch gekennzeichnet, daß es sich bei den Verbrauchern um Quellen elektromagnetischer Strahlung beliebiger Frequenz handelt.

# Fig. 1

S

HV

I 1    I2

K 1    K 2

P1    E 1    P1    P2    E 2    P2

Oszillator    Verstärker

---

# Fig. 2

S1    C1

L 1

HV

L 4    S 2

L 2    L 3

C 2    C 3

A 1    A 2

E 1    C 4    L 5    L 6    E 2    C 5

Oszillator    Verstärker

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | REVIEW OF SCIENTIFIC INSTRUMENTS, Band 55, Nr. 4, April 1984, Seiten 477-481, New York, US; F. DOCCHIO et al.: "Thyratron-switched N2 atmospheric-pressure oscillator, low-pressure amplifier laser system" * Figur 1 * | 1 | H 03 K 3/55 H 01 S 3/097 |
| | --- | | |
| D,A | DE-A-3 335 690 (LAMBDA PHYSIK GMBH) * Figur 3; Seite 9, Zeilen 4-37; Patentansprüche 1, 2 * | 1,2 | |
| | --- | | |
| A | LASER UND OPTOELEKTRIK, Band 17, Nr. 2, Juni 1985, Seiten 141-148, Stuttgart; H. PUMMER et al.: "Kommerzielle Excimerlaser" * Figur 2 * | 1 | RECHERCHIERTE SACHGEBIETE (Int. Cl.4) |
| | --- | | H 01 S 3/097 H 03 K 3/53 H 03 K 3/55 |
| A | EP-A-0 108 299 (KRAFTWERK UNION AG; & DE - A - 3 240 372 (Kat. D,A)) | | |
| | ----- | | |

Der vorliegende Recherchenbericht wurde für alle Patentansprüche erstellt.

| BERLIN Recherchenort | 25-11-1986 Abschlußdatum der Recherche | ARENDT M Prüfer |
|---|---|---|

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82